# EUROPÄISCHE PATENTSCHRIFT

(11) **EP 1 490 911 B1**
(45) Veröffentlichungstag und Bekanntmachung des Hinweises auf die Patenterteilung: **16.07.2008**
(21) Anmeldenummer: 03714890.5
(22) Anmeldetag: 27.03.2003
(51) Int. Cl.: H01L 31/0224, H01L 31/115

(54) **LEITUNGSÜBERFÜHRUNG FÜR EINEN HALBLEITER-DETEKTOR**
CONDUCTOR CROSSOVER FOR A SEMICONDUCTOR DETECTOR
INTERCONNEXION DE LIGNE DESTINEE A UN DETECTEUR A SEMI-CONDUCTEURS

(30) Priorität: 27.03.2002 DE 10213812
(43) Veröffentlichungstag der Anmeldung: 29.12.2004
(73) Patentinhaber: Max-Planck-Gesellschaft zur Förderung der Wissenschaften e.V., 80539 München (DE)
(72) Erfinder: STRÜDER, Lothar, 80803 München (DE); LUTZ, Gerhard, 81739 München (DE); RICHTER, Rainer, 81243 München (DE)
(74) Vertreter: Beier, Ralph
(86) Internationale Anmeldenummer: PCT/EP2003/003209
(87) Internationale Veröffentlichungsnummer: WO 2003/081637

(56) Entgegenhaltungen:
- DE-A- 3 427 476
- US-A- 4 729 005
- US-A1- 2002 139 970
- STRUDER L: "High-resolution imaging X-ray spectrometers" NUCLEAR INSTRUMENTS & METHODS IN PHYSICS RESEARCH, SECTION - A: ACCELERATORS, SPECTROMETERS, DETECTORS AND ASSOCIATED EQUIPMENT, NORTH-HOLLAND PUBLISHING COMPANY. AMSTERDAM, NL, Bd. 454, Nr. 1, 1. November 2000 (2000-11-01), Seiten 73-113, XP004238224 ISSN: 0168-9002 in der Anmeldung erwähnt
- CASTOLDI A. ET AL: 'The controlled-drift detector' NUCLEAR INSTRUMENTS AND METHODS IN PHYSICS RESEARCH A Bd. 439, 2000, Seiten 519 - 528
- MISIAKOS K. ET AL: 'A silicon drift detector with a P-type JFET integrated in a N-well anode' NUCLEAR INSTRUMENTS AND METHODS IN PHYSICS RESEARCH A Bd. 458, 2001, Seiten 422 - 426

## Beschreibung

Die Erfindung betrifft eine Leitungsüberführung für einen Halbleiter-Detektor, insbesondere für einen Driftdetektor zur Röntgenspektroskopie, gemäß dem Oberbegriff des Anspruchs 1.

Halbleiter-Detektoren zur Erfassung elektromagnetischer Strahlung basieren auf der Messung von freien Ladungsträgern, die durch die Strahlung in einem Halbleiterbauelement generiert werden. Mit den Ladungsträgern wird ein elektrisches Signal gebildet, das über mindestens eine Anschlussleitung zu einer Messeinrichtung überführt wird. Die Ausbildung der Anschlussleitung stellt ein generelles Problem bei der Gestaltung von Halbleiter-Detektoren dar. Der Detektor muss mit der Anschlussleitung praktikabel herstellbar und handhabbar sein, es darf durch die Anschlussleitung nicht zu einer Beeinträchtigung der Detektorfunktion kommen.

Es sind beispielweise Halbleiter-Detektoren zur ortsaufgelösten Strahlungsdetektion mit mehreren, in einem Halbleitersubstrat angeordneten Halbleiterelektroden bekannt (sog. Streifen- oder Spuren-Detektoren). Bei diesen werden isolierte Anschlussleitungen unmittelbar über die Halbleiterelektroden zu einem Substratrand geführt. Eine derartige Leitungsüberführung ist jedoch nur möglich, wenn zwischen der Anschlussleitung und den Halbleiterelektroden kein störender Potentialunterschied besteht.

In der Röntgenspektroskopie sind zur hochauflösenden Strahlungsdetektion Driftdetektoren bekannt (siehe L. Strüder in "Nuclear Instruments and Methods in Physics Research A", Bd. 454, 2000, S. 73-113, und beispielsweise DE 34 27 476 A1). Ein Driftdetektor umfasst beispielsweise ein Halbleitersubstrat aus schwach n-dotiertem Silizium, das auf einer Oberfläche (Oberseite) eine stark n-dotierte, mittig angeordnete Anode und auf der entgegengesetzten Oberfläche (Unterseite) einen Rückkontakt aus einem stark p-dotierten Halbleitermaterial aufweist. Auf der Oberseite sind ferner ringförmige, konzentrisch um die Anode angeordnete Halbleiterelektroden aus einem stark p-dotierten Halbleitermaterial vorgesehen. Die Halbleiterelektroden werden jeweils auf einem festen elektrischen Potential gehalten, das mit zunehmendem Abstand von der Anode negativer wird. Dies führt zum einen im Wirkungsbereich der Elektroden zu einer vollständigen Verarmung des Halbleitersubstrats und zum anderen zur Erzeugung eines elektrischen Driftfeldes im Halbleitersubstrat. Durch Strahlungswechselwirkung werden im Halbleitersubstrat freie Elektronen generiert, die durch das Driftfeld zur Anode getrieben werden, so dass das elektrische Signal an der Anode ein Maß für die Energie und/oder Intensität der Strahlung ist.

Die Gestaltung der Anschlussleitung der Anode stellt bei Driftdetektoren bisher ein erhebliches Problem dar. Die o. g. Führung der Anschlussleitung über die Halbleiterelektroden würde wegen hoher Potentialunterschiede zwischen der Anschlussleitung und dem Halbleitersubstrat mit den Halbleiterelektroden zu Fehlsignalen durch unerwünschte Ladungsträgervervielfachungen und/oder zu elektrischen Durchbrüchen führen. Die bekannten Silizium-Driftdetektoren zeichnen sich daher durch eine frei geführte Kontaktierung der Anode von der Oberseite des Halbleitersubstrats her aus. Elektrische Anschlussleitungen werden von der Anode zu einer räumlich getrennten Anschlusseinheit oder Messeinrichtung frei durch den zur Oberseite benachbarten Halbraum geführt.

Die freie Führung von Anschlussleitungen gemäß DE 34 27 476 A1 besitzt mehrere Nachteile. Die elektrische Kontaktierung ist schwierig, da die Anschlussleitungen üblicherweise mit einem Ultraschallbonding aufgebracht werden, bei dem das Halbleitersubstrat zu unerwünschten mechanischen Schwingungen neigt. Es können Fehlkontaktierungen auftreten. Falls beim Bonden das Halbleitersubstrat im sensitiven Bereich beschädigt wird, kann es zu einem Ausfall des Detektors kommen. Des Weiteren besitzt die freie Führung von Anschlussleitungen Nachteile in Bezug auf die Stabilität der Kontaktierung und die Kombination von Driftdetektoren in Gruppen.

Aus Misiakos, K. et al, "A silicon drift detector with a P-type JFET integrated in N-well anode", Nuclear Instruments and Methods in Physics Research, A 458 (2001) 422 - 426 sind Leitungsüberführungen von einem im Anodengebiet angeordneten JFET zum Rand des Detektors vorgesehen, was jedoch nur dann möglich ist, wenn zwischen der Leitungsüberführung und den Halbleiterelektroden kein störender Potentialunterschied besteht.

Schließlich ist auch aus Castoldi, A. et al, " The controlleddrift detector, Nuclear Instruments and Methods in Physics Research, A 439 (2000) 519-528 ein Driftdetektor bekannt, bei dem die Oxidschicht auf der Vorderseite des Detektors mit Metallschichten (Feldplatten) bedeckt ist, um den Oberflächengenerationsstrom zu unterdrücken, der an der Grenzfläche zwischen dem Silizium und dem Siliziumdioxid entstehen kann. Durch die Feldplatten werden hierbei in Verbindung mit den im Siliziumdioxid enthaltenen positiven fest sitzenden Ladungen thermisch generierte Elektroden an besagter Grenzfläche festgehalten. Die Elektronen besetzen die in der Halbleiterbandlücke vorhandenen Energieniveaus, so dass eine weitere thermische Generation an dieser Stelle weitgehend unterdrückt wird. Die Funktion der Feldplatten besteht hierbei also in der Einstellung eines hinreichend positiven Grenzflächenpotentials, um die Elektronen an dieser Stelle zu halten. Eine Leitungsüberführung entsprechend der Erfindung geht jedoch aus dieser Druckschrift nicht hervor.

Der Erfindung liegt die Aufgabe zugrunde, eine verbesserte Leitungsüberführung für einen Halbleiter-Detektor zu schaffen, mit der die Nachteile herkömmlicher Leitungsüberführungen überwunden werden und die insbesondere bei großen Potentialunterschieden zwischen einer Anschlussleitung und Halbleiterelektroden einsetzbar ist, wie sie beispielsweise beim oben beschriebenen Driftdetektor auftreten.

Diese Aufgabe wird, ausgehend von einer Leitungsüberführung gemäß dem Oberbegriff des Anspruchs 1, durch die kennzeichnenden Merkmale des Anspruchs 1 gelöst.

Eine Grundidee der Erfindung ist es, eine Leitungsüberführung für einen Halbleiter-Detektor mit einem Halbleitersubstrat und Halbleiterelektroden bereitzustellen, wobei mit der Leitungsüberführung mindestens eine Anschlussleitung z. B. von einer signalgebenden Ausleseelektrode zu einer Messeinrichtung über die Halbleiterelektroden und das Halbleitersubstrat oder über mindestens einen benachbarten Detektor hinweggeführt wird und zwischen der Anschlussleitung und dem Halbleitersubstrat mindestens eine Zwischenelektrode angeordnet ist, die relativ zur Anschlussleitung und zum benachbarten Halbleitersubstrat elektrisch isoliert ist und mindestens einen Teilbereich des Halbleitersubstrats zwischen den Halbleiterelektroden gegenüber der Anschlussleitung elektrisch abschirmt.

Durch die Bereitstellung der Zwischenelektrode ergeben sich eine Reihe von Vorteilen. Die Zwischenelektrode kann auf einem vorgegebenen elektrischen Potential gehalten werden, so dass Störungen der Detektorfunktion durch das Potential der Anschlussleitung vermieden werden. Es können vorteilhafterweise die Beschränkungen herkömmlicher Leitungsüberführungen auf geringe Potentialunterschiede überwunden werden. Die elektrische Verbindung der Anschlussleitung mit einer Messeinrichtung durch Bonden kann im nicht-sensitiven Bereich des Detektors am Rand des Halbleitersubstrats mit Abstand von der Anode erfolgen. Dies vereinfacht die Kontaktierung, Detektorausfälle durch Substratschäden werden vermieden.

Gemäß einer vorteilhaften Ausführungsform der Erfindung überdeckt die Zwischenelektrode zur elektrischen Abschirmung des Halbleitersubstrates den Zwischenraum zwischen benachbarten Halbleiterelektroden vollständig. Die Breite der Zwischenelektrode ist vorzugsweise größer als der laterale Abstand zwischen benachbarten Halbleiterelektroden. Es können zur Vereinfachung der Bauelementstruktur mit einer einzelnen Zwischenelektrode auch mehrere Zwischenräume zwischen benachbarten Halbleiterelektroden überdeckt werden. Es ist alternativ möglich, dass die Zwischenelektrode zwei- oder mehrteilig ist und jeweils nur einen Teilbereich des Zwischenraums zwischen den benachbarten Halbleiterelektroden abschirmt. Vorzugsweise schirmt die Zwischenelektrode mit ihren einzelnen Teilen den Übergang zwischen dem Halbleitersubstrat und einer Halbleiterelektrode ab.

Die Festlegung des elektrischen Potentials der Zwischenelektrode erfolgt vorzugsweise dadurch, dass diese elektrisch mit einer der benachbarten Halbleiterelektroden verbunden ist, wodurch der Potentialunterschied zwischen der Zwischenelektrode und den benachbarten Halbleiterelektroden gering gehalten wird. Das Potential der Zwischenelektrode kann alternativ dadurch festgelegt werden, dass die Zwischenelektrode mit einer externen Spannungsquelle verbunden ist.

Die Zwischenelektrode besteht aus einem elektrisch leitfähigen Material, wie beispielsweise Metall, einem intrinsischen oder dotierten Halbleiter oder einem Widerstandsmaterial. Vorteilhafterweise werden an die Leitfähigkeit der Zwischenelektrode und ggf. der elektrischen Verbindung der Zwischenelektrode mit einer der Halbleiterelektroden keine besonderen Anforderungen gestellt, da die Zwischenelektrode lediglich der elektrostatischen Abschirmung dient. Es kann eine schlecht leitende Verbindung vorgesehen sein, da die Zwischenelektrode keine elektrische Leistung führen muss. Beispielsweise kann eine Zwischenelektrode aus Polysilizium direkt mit einer der Halbleiterelektroden aus Silizium verbunden werden. Durch den direkten Polysilizium-Silizium-Übergang, der sonst in Halbleiterbauelementen vermieden wird, vereinfacht sich der Aufbau des erfindungsgemäßen Detektors.

Gemäß einer weiteren vorteilhaften Ausführungsform der Erfindung können zur Verbesserung der elektrischen Abschirmung übereinander mehrere Ebenen mit Zwischenelektroden vorgesehen sein, wobei die einzelnen Ebenen durch zusätzliche Isolationsschichten gegeneinander isoliert sind. Eine derartige mehrlagige Anordnung der Zwischenelektroden ist insbesondere dann vorteilhaft, wenn die Anschlussleitung einen sehr großen Potentialunterschied (z. B. im kV-Bereich) gegenüber den Halbleiterelektroden aufweist.

In einer vorteilhaften Variante der Erfindung ist darüber hinaus mindestens eine Abschirmungselektrode mit einem festen elektrischen Potential vorgesehen, die zwischen der Anschlussleitung und dem Halbleitersubstrat angeordnet ist. Bei einer mittigen Anordnung der signalgebenden Ausleseelektrode (Anode) auf dem Halbleitersubstrat ist die mindestens eine Abschirmungselektrode vorzugsweise am äußeren Rand des Halbleitersubstrats angeordnet. Zur Verbesserung der elektrischen Abschirmung können mehrere Abschirmungselektroden vorgesehen sein, die jeweils ein festes elektrisches Potential aufweisen.

Die erfindungsgemäße Führung der Anschlussleitung ist nicht auf die Kontaktierung der Ausleseelektrode beschränkt, sondern in gleicher Weise auf die Kontaktierung der einzelnen Halbleiterelektroden anwendbar. Auf diese Weise können sämtliche Anschlussleitungen sowohl für die Ausleseelektrode als auch für die Halbleiterelektroden nach außen geführt werden, so dass eine einfache und mechanisch sichere Kontaktierung möglich ist. Falls die Ausleseelektrode mit einem Verstärkungselement (z. B. Transistor) integriert auf dem Halbleitersubstrat angeordnet ist, kann die erfindungsgemäße Leitungsüberführung auch zum Anschluss des Verstärkungselements, z. B. für die Anschlusskontakte des Transistors, verwendet werden. Mit einer Zwischenelektrode können mehrere Anschlussleitungen abgeschirmt werden.

Die Erfindung ist nicht auf bestimmte Dotierungsverhältnisse im Detektor beschränkt. Es können beispielsweise ein schwach n-dotiertes Halbleitersubstrat mit stark p-dotierten Halbleiterelektroden und einer Ausleseelektrode aus stark n-dotiertem Halbleitermaterial oder umgekehrt ein schwach p-dotiertes Halbleitersubstrat mit stark n-dotierten Halbleiterelektroden und einer stark p-dotierten Ausleseelektrode vorgesehen sein.

Bei einem Röntgen-Driftdetektor sollte das Halbleitersubstrat so schwach dotiert sein, dass das Halbleitersubstrat im normalen Betrieb vollständig verarmt, damit im unbestrahlten Halbleitersubstrat keine freien Ladungsträger vorhanden sind. Entsprechend sollten die Halbleiterelektroden und die Ausleseelektrode aus einem Material bestehen, das so stark dotiert ist, dass im normalen Betrieb keine vollständige Verarmung erfolgt.

Die Umsetzung der Erfindung ist nicht auf die Verwendung von Silizium oder Polysilizium als Halbleitermaterial beschränkt. Vielmehr könnten die einzelnen Halbleiterkomponenten auch aus anderen Materialien gefertigt sein, wie beispielsweise Germanium oder Gallium-Arsenid. Die Verwendung von Silizium als Halbleitermaterial bietet jedoch den Vorteil einer kostengünstigen Verfügbarkeit und ausgereiften Technologie.

Gemäß einer weiteren vorteilhaften Ausführungsform der Erfindung ist die mindestens eine Anschlussleitung über Halbleiterelektroden mit einer ringförmigen Topologie geführt. Eine ringförmige Topologie wird zum Beispiel durch kreisförmige, ovale, polygone oder nicht-konzentrisch geschlossen verlaufende Elektroden gebildet. Es sind ggf. mehrere Halbleiterelektroden vorgesehen, die sich gegenseitig umschließen.

Ein weiterer Vorteil der erfindungsgemäßen Leitungsüberführung betrifft die Kombination von Halbleiter-Detektoren in Gruppen. Zum einen können großflächige Detektoranordnungen oder -arrays z. B. mit einer Vielzahl von wabenförmig aneinander angrenzenden Driftdetektoren einfacher kontaktiert werden, da die Anschlussleitungen von mehreren Driftdetektoren an den Rand der Detektoranordnung geführt und dort kontaktiert werden können. Anschlussleitungen können nicht nur über einen Driftdetektor zu dessen Rand, sondern über eine Vielzahl von Detektoren geführt werden, ohne deren Funktion zu beeinträchtigen. Zum anderen ermöglicht die erfindungsgemäße Führung der Anschlussleitungen eine eng gestapelte Anordnung mehrerer Driftdetektoren übereinander, ohne dass zwischen den einzelnen Driftdetektoren störendes Streu- oder Absorptionsmaterial angeordnet ist.

Für ein Detektorarray weist jedes Halbleitersubstrat vorzugsweise die Form einer hexagonalen Scheibe auf, so dass zahlreiche Detektoren lückenlos aneinander angrenzend angeordnet werden können. Die Halbleiterelektroden verlaufen hierbei vorzugsweise entsprechend einem hexagonalen Ring. Die hexagonale Form ist vorteilhafterweise die Polygonform, die am besten einer Kreisfläche angenähert ist und damit eine große Detektorfläche bietet und andererseits überlappungsfrei in dichter Packung in einer Ebene angeordnet werden kann. Besonders vorteilhaft ist die monolithische Integration einer Vielzahl hexagonaler Driftdetektoren auf einem Wafer.

Es ist alternativ möglich, dass das Halbleitersubstrat kreisscheibenförmig ist, wobei die Halbleiterelektroden vorzugsweise kreisringförmig sind. Schließlich ist es auch möglich, dass die einzelnen Halbleiterelektroden linear angeordnet sind und parallel zueinander verlaufen, wobei die Ausleseelektrode dann vorzugsweise neben den Halbleiterelektroden angeordnet ist.

Weitere vorteilhafte Weiterbildungen der Erfindung sind in den Unteransprüchen gekennzeichnet oder werden nachstehend zusammen mit der Beschreibung der bevorzugten Ausführungsbeispiele anhand der Zeichnungen näher erläutert. Es zeigen:
- Fig. 1:: eine Querschnittsdarstellung eines Driftdetektors mit einem ersten Ausführungsbeispiel einer erfindungsgemäßen Leitungsüberführung,
- Fig. 2:: eine Detektordarstellung mit einem alternativen Ausführungsbeispiel einer Leitungsüberführung mit zusätzlichen Abschirmungselektroden,
- Fig. 3:: eine Detektordarstellung mit einem alternativen Ausführungsbeispiel einer Leitungsüberführung, bei der mehrere Ebenen von Zwischenelektroden übereinander angeordnet sind, und
- Fig. 4:: eine Draufsicht eines Driftdetektors mit mehreren erfindungsgemäßen Leitungsüberführungen.

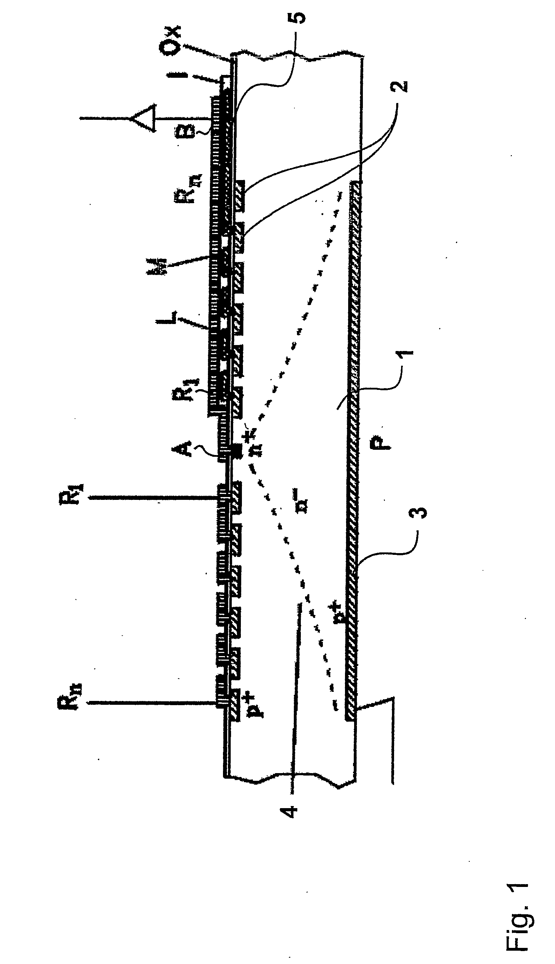

In Fig. 1 ist ein Silizium-Driftdetektor im Querschnitt vergrößert dargestellt, der beispielsweise in der Röntgenspektroskopie verwendet werden kann. Der zylinderförmige Driftdetektor umfasst ein Halbleitersubstrat 1, auf dessen Oberflächen dotierte Bereiche Halbleiterelektroden 2, 3 und A bilden. Die Strahlungsdetektion erfolgt durch die Erfassung von Elektronen, die durch die Strahlung im Halbleitersubstrat 1 freigesetzt werden, wobei die Halbleiterelektroden in an sich bekannter Weise zusammenwirken, wie es beispielsweise von L. Strüder in der o.g. Publikation beschrieben ist. Das Halbleitersubstrat 1 besteht aus einer n-dotierten Silizium-Scheibe, wobei die Dotierung so schwach ist, dass das Halbleitersubstrat 1 im sensitiven Bereich vollständig verarmt. Das Halbleitersubstrat 1 besitzt beispielsweise eine Dicke von ungefähr 300 µm und einen Durchmesser, der je nach Anwendung wenige mm, z. B. ungefähr 2,5 mm, oder bis einige cm, z. B. 10 cm beträgt.

An der Oberseite (bezogen auf Figur 1) des Halbleitersubstrats 1 ist mittig die Ausleseelektrode A angeordnet, die aus einem n-dotierten Halbleitermaterial besteht. Die Dotierung der Ausleseelektrode A ist so stark, dass im Betrieb keine vollständige Verarmung auftritt. Vorteilhaft an der dargestellten Anordnung der Ausleseelektrode A ist deren niedrige Kapazität, so dass auch Strahlung geringer Energie und geringer Einwirkdauer spektroskopisch erfasst werden können.

Mehrere ringförmige Halbleiterelektroden 2 sind an der Oberseite des Halbleitersubstrats 1 angeordnet, die die Ausleseelektrode A konzentrisch umgegeben. Die einzelnen Halbleiterelektroden 2 bestehen jeweils aus einem p-dotierten Halbleitermaterial, wobei die Dotierung der Halbleiterelektroden 2 so stark sind, dass im Betrieb keine vollständige Verarmung auftritt. Die Halbleiterelektroden werden auch als Feldringe R1 bis Rn bezeichnet.

Auf der Oberseite des Halbleitersubstrats 1 ist eine erste Isolationsschicht Ox vorgesehen, die zur Herstellung elektrischer Verbindungen die Ausleseelektrode A und ggf. Teile der Halbleiterelektroden 2 freilässt. Auf der Unterseite des Halbleitersubstrats 1 ist gegenüber der Ausleseelektrode A und den Halbleiterelektroden 2 eine flächige Gegenelektrode 3 angeordnet. Die Gegenelektrode 3 besteht aus einem p-dotierten Halbleitermaterial, wobei die Dotierung so stark ist, dass im Betrieb keine vollständige Verarmung der Gegenelektrode 3 auftritt.

Die einzelnen Halbleiterelektroden 2 werden von der Mitte zum Rand mit einem zunehmend negativen elektrischen Potential beaufschlagt, wodurch sich im Inneren des Halbleitersubstrats 1 das o.g. elektrische Driftfeld aufbaut, das die durch Strahlung im Halbleitersubstrat 1 freigesetzten Elektronen in Richtung der Ausleseelektrode A treibt. Die Minima der Potentiallinien des Elektronenpotentials liegen auf einer Kurve 4, entlang der die freigesetzten Elektronen in Richtung der Ausleseelektrode A wandern.

Die Ansteuerung der Halbleiterelektroden 2 erfolgt durch einen integrierten Spannungsteiler (siehe linker Teil von Figur 1), der z. B. aus einer Kette von MOS-Anreicherungstransistoren besteht, die in Durchgangsrichtung betrieben werden. Die Breite der einzelnen MOS-Anreicherungstransistoren kann klein im Vergleich zum Umfang der ringförmigen Halbleiterelektroden 2 sein. Die MOS-Anreicherungstransistoren werden jeweils durch Überführung eines Leiters über die an der Oberseite des Halbleitersubstrats 1 angeordnete Isolationsschicht Ox zwischen benachbarten Halbleiterelektroden 2 gebildet, so dass zwischen den einzelnen Halbleiterelektroden 2 jeweils etwa die Schwellenspannung des Transistors abfällt. Alternativ kann zur Ansteuerung der Halbleiterelektroden ein resistiver Spannungsteiler oder eine punchthrough-Struktur vorgesehen sein.

Im Folgenden wird die Kontaktierung der Ausleseelektrode A mit der erfindungsgemäßen Leitungsüberführung beschrieben. Die Ausleseelektrode A ist mit einer Anschlussleitung M verbunden, die über die ringförmigen Halbleiterelektroden 2 nach außen zu einem Bond-Pad B geführt ist. Zwischen der Anschlussleitung M und den Halbleiterelektroden 2 befinden sich mehrere Zwischenelektroden L. Die Zwischenelektroden L sind strukturierte Teilschichten mit einer Fläche, die in radialer Richtung den Zwischenraum zwischen jeweils zwei benachbarten Halbleiterelektroden 2 vollständig überdeckt und quer dazu mindestens so breit wie die Anschlussleitung M ist. Die radiale Ausdehnung der Zwischenelektroden L ist vorzugsweise so gewählt, dass in senkrechter Projektion eine Überlappung der Halbleiterelektroden 2 gegeben ist, wobei die Überlappung z. B. dem zwei- bis drei-fachen Wert der Dicke der Isolationsschicht Ox ist. Mit den Zwischenelektroden L wird das Halbleitersubstrat 1 elektrisch abgeschirmt, um zu verhindern, dass im Halbleitersubstrat 1 zwischen den Halbleiterelektroden 2 aufgrund der Feldwirkung der Anschluss.leitung M Ladungsträgervervielfältigungen oder elektrische Durchbrüche auftreten. Zwischen der Anschlussleitung M und den einzelnen Zwischenelektroden L befindet sich eine weitere Isolationsschicht I, um die Anschlussleitung M von den einzelnen Zwischenelektroden zu isolieren.

Die einzelnen Zwischenelektroden L werden jeweils auf einem festen elektrischen Potential gehalten, indem jede einzelne Zwischenelektrode L mit einer der beiden benachbarten Halbleiterelektroden elektrisch verbunden ist.

Schließlich weist der Driftdetektor eine Außenelektrode 5 auf, die vorzugsweise nach außen bis über das Bond-Pad B hinausgeführt ist.

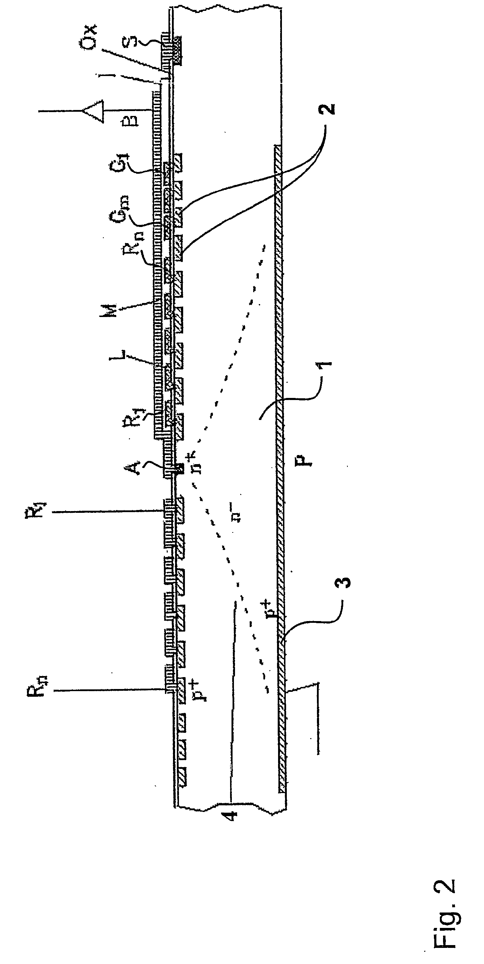

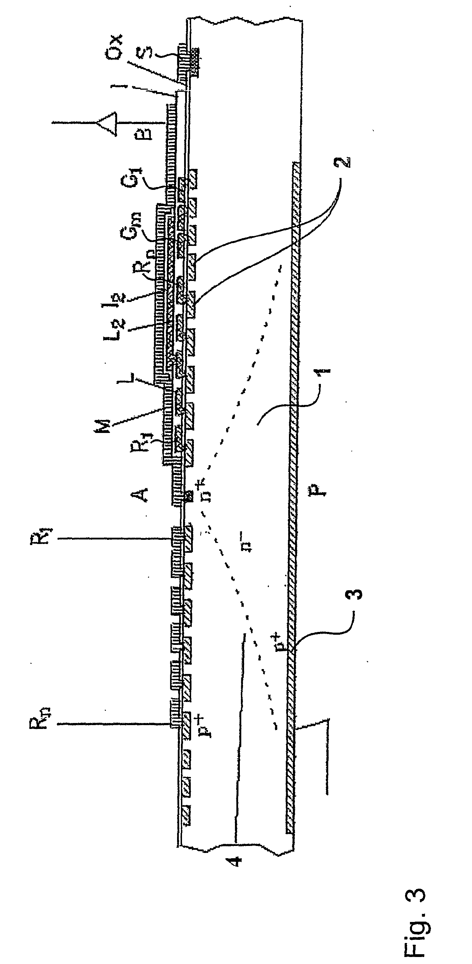

Die in den Fign. 2 und 3 dargestellte Ausführungsbeispiele erfindungsgemäßer Leitungsüberführungen stimmen weitgehend mit dem vorstehend beschriebenen Ausführungsbeispiel überein, so dass für entsprechende Elemente dieselben Bezugszeichen verwendet werden und zur Vermeidung von Wiederholungen auf die Beschreibung zu Fig. 1 verwiesen wird.

Die Besonderheit des Ausführungsbeispiels gemäß Fig. 2 besteht darin, dass an der Oberseite des Halbleitersubstrats 1 im Außenbereich mehrere ringförmige, konzentrisch angeordnete Abschirmungselektroden G₁-Gₘ angeordnet sind, die sich auf ein elektrisches Potential einstellen, das von innen nach außen bis auf das Potential einer Substratelektrode S abnimmt, die das Potential des Halbleitersubstrats im Randbereich festlegt.

Die Besonderheit des Ausführungsbeispiels gemäß Fig. 3 besteht darin, dass zwischen der Anschlussleitung M und den einzelnen Halbleiterelektroden 2 zwei Ebenen von Zwischenelektroden L, L₂ angeordnet sind. Die mehrlagige Anordnung der Zwischenelektroden L, L₂ verhindert auch bei sehr hohen Spannungen zwischen der Anschlussleitung M und den Halbleiterelektroden 2 Störungen der Detektorfunktion durch das Feld der Anschlussleitung M.

Zwischen der Anschlussleitung M und der zusätzlichen Zwischenelektrode L₂ ist eine weitere Isolationsschicht I₂ angeordnet, um die Anschlussleitung M gegenüber der Zwischenelektrode L₂ zu isolieren.

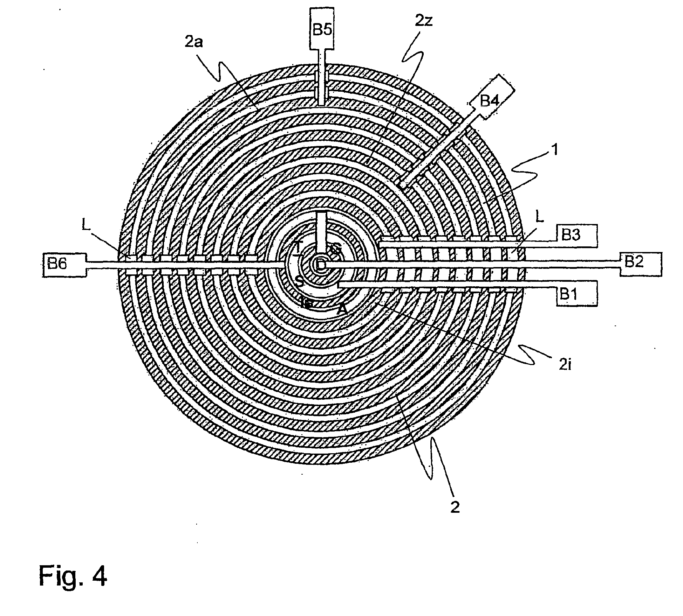

Fig. 4 zeigt einen Driftdetektor in Draufsicht, bei dem die Ausleseelektrode mit einem Feldeffekt-Transistor integriert auf dem Halbleitersubstrat angeordnet ist. In der Draufsicht sind die p-dotierten Bereiche (Halbleiterelektroden 2, 2a, 2z, 2i, Gate G) schraffiert und die n-dotierten Bereiche (freiliegenden Gebiete des Halbleitersubstrates 1, Drain D, Source S) unschraffiert gezeigt. Der Transistor Tr umfasst den n-dotierten, zentralen Drain-Bereich D, den p-dotierten, ringförmigen Gate-Bereich G und den n-dotierten, ringförmige Source-Bereich S. Der Gate-Bereich G ist mit der Anode A (Ausleseelektrode) verbunden. Die Anschlusskontakte des Transistors Tr sind einzeln jeweils mit einer erfindungsgemäßen Leitungsüberführung zum äußeren Rand des Driftdetektors geführt. Des weiteren sind Halbleiterelektroden 2 gruppenweise mit Leitungsüberführungen mit äußeren Kontaktstellen (Bond-Pad's) verbunden. Mit erfindungsgemäß vorgesehenen Zwischenelektroden L können Anschlussleitungen einzeln oder in Gruppen abgeschirmt werden.

Beim dargestellten Beispiel sind die Bond-Pad's B1 bis B6 entsprechend mit dem Source S, dem Drain D, der innersten Halbleiterelektrode 2i, einer zwischenliegenden Halbleiterelektrode 2z, einer äußeren Halbleiterelektrode 2a und einem p-dotierten Isolationsring Is zwischen dem Source S und der Anode A verbunden. Die beiden äußersten Ringe sind Abschirmungselektroden (Guard-Elektroden), die dem Potentialabbau dienen und nicht kontaktiert sind. Ein Substratkontakt (nicht dargestellt) ist außerhalb des äußersten Ringes vorgesehen.

## Patentansprüche

1. Leitungsüberführung für einen Halbleiter-Detektor, insbesondere für einen Driftdetektor zur Röntgenspektroskopie, mit
- mindestens zwei in einem Halbleitersubstrat (1) angeordneten dotierten Halbleiterelektroden (2),
- mindestens einer über die Halbleiterelektroden (2) geführten Anschlussleitung (M), und
- einer ersten Isolationsschicht (Ox),
**dadurch gekennzeichnet, dass**
zwischen der Anschlussleitung (M) und der ersten Isolationsschicht (Ox) eine Zwischenelektrode (L, L2) angeordnet ist, die den Bereich des Halbleitersubstrats (1) zwischen den Halbleiterelektroden (2) überdeckt und durch mindestens eine weitere Isolationsschicht (I) gegenüber der Anschlussleitung (M) elektrisch isoliert ist, wobei die mindestens eine Zwischenelektrode (L, L2) mindestens einen Teilbereich des Halbleitersubstrats (1) zwischen den Halbleiterelektroden (2) gegenüber der Anschlussleitung (M) elektrisch abschirmt.

2. Leitungsüberführung nach Anspruch 1, **dadurch gekennzeichnet, dass** die Zwischenelektrode (L) elektrisch mit einer der Halbleiterelektroden (2) verbunden ist und deren elektrisches Potential aufweist.

3. Leitungsüberführung nach Anspruch 2, bei der die Verbindung zwischen der Zwischenelektrode (L) und der Halbleiterelektrode (2) durch einen Polysilizium-Silizium-Übergang gebildet wird.

4. Leitungsüberführung nach Anspruch 1, **dadurch gekennzeichnet, dass** die Zwischenelektrode (L, L2) zur Festlegung ihres elektrischen Potentials mit einer externen Spannungsquelle verbunden ist.

5. Leitungsüberführung nach mindestens einem der vorhergehenden Ansprüche, **dadurch gekennzeichnet, dass** zwischen der Anschlussleitung (M) und dem Halbleitersubstrat (1) übereinander mehrere Ebenen mit mehreren isolierten Zwischenelektroden (L, L2) angeordnet sind.

6. Leitungsüberführung nach mindestens einem der vorhergehenden Ansprüche, **dadurch gekennzeichnet, dass** zur Kontaktierung der Halbleiterelektroden (2) und/oder eines Verstärkungselements (T) mindestens eine weitere Anschlussleitung vorgesehen ist, die über benachbarte Halbleiterelektroden (2) geführt ist.

7. Leitungsüberführung nach mindestens einem der vorhergehenden Ansprüche, **dadurch gekennzeichnet, dass** die Halbleiterelektroden (2) p-dotiert sind, während das Halbleitersubstrat (1) und/oder die Ausleseelektrode (A) n-dotiert ist.

8. Leitungsüberführung nach mindestens einem der Ansprüche 1 bis 6, **dadurch gekennzeichnet, dass** die Halbleiterelektroden (2) n-dotiert sind, während das Halbleitersubstrat (1) p-dotiert ist.

9. Leitungsüberführung nach mindestens einem der vorhergehenden Ansprüche, **dadurch gekennzeichnet, dass** das Halbleitersubstrat (1), die Halbleiterelektroden (2) und/oder die Substratelektrode (S) im wesentlichen aus Silizium, insbesondere Polysilizium, Germanium oder Gallium-Arsenid bestehen.

10. Leitungsüberführung nach mindestens einem der vorhergehenden Ansprüche, **dadurch gekennzeichnet, dass** die Anschlussleitung (M) über Halbleiterelektroden (2) mit einer ringförmigen Topologie geführt ist.

11. Leitungsüberführung nach Anspruch 10, **dadurch gekennzeichnet, dass** die Anschlussleitung (M) über mehrere Halbleiterelektroden (2) geführt ist, die sich gegenseitig umschließen.

12. Leitungsüberführung nach mindestens einem der vorhergehenden Ansprüche, **dadurch gekennzeichnet, dass** die mindestens eine Anschlussleitung über eine Vielzahl von benachbarten Driftdetektoren geführt wird.

13. Driftdetektor zur Röntgenspektroskopie, der mit mindestens einer Leitungsüberführung nach mindestens einem der vorhergehenden Ansprüche ausgestattet ist.

14. Detektoranordnung zur Röntgenspektroskopie, die eine Vielzahl von Driftdetektoren umfasst und mit mindestens einer Leitungsüberführung nach mindestens einem der vorhergehenden Ansprüche 1 bis 12 ausgestattet ist, die über mehrere Driftdetektoren geführt ist.

## Claims

1. Conductor crossover for a semiconductor detector, in particular for a drift detector for X-ray spectroscopy, having
- at least two doped semiconductor electrodes (2) which are disposed in a semiconductor substrate (1),
- at least one connection line (M) which is guided over the semiconductor electrodes (2), and
- a first insulation layer (Ox),
**characterised in that**
an intermediate electrode (L, L2) is disposed between the connection line (M) and the first insulation layer (Ox), said intermediate electrode covering the region of the semiconductor substrate (1) between the semiconductor electrodes (2) and being electrically insulated relative to the connection line (M) by at least one further insulation layer (I), the at least one intermediate electrode (L, L2) electrically screening at least one partial region of the semiconductor substrate (1) between the semiconductor electrodes (2) relative to the connection line (M).

2. Conductor crossover according to claim 1, **characterised in that** the intermediate electrode (L) is connected electrically to one of the semiconductor electrodes (2) and has the electrical potential thereof.

3. Conductor crossover according to claim 2, in which the connection between the intermediate electrode (L) and the semiconductor electrode (2) is formed by a polysilicon-silicon transition.

4. Conductor crossover according to claim 1, **characterised in that** the intermediate electrode (L, L2) is connected to an external voltage source in order to fix its electrical potential.

5. Conductor crossover according to at least one of the preceding claims, **characterised in that** a plurality of planes which are disposed one above the other and have a plurality of insulated intermediate electrodes (L, L2) are disposed between the connection line (M) and the semiconductor substrate (1).

6. Conductor crossover according to at least one of the preceding claims, **characterised in that**, in order to contact the semiconductor electrodes (2) and/or a reinforcing element (T), at least one further connection line is provided which is guided over adjacent semiconductor electrodes (2).

7. Conductor crossover according to at least one of the preceding claims, **characterised in that** the semiconductor electrodes (2) are p-doped, whilst the semiconductor substrate (1) and/or the read-out electrode (A) is n-doped.

8. Conductor crossover according to at least one of the preceding claims 1 to 6, **characterised in that** the semiconductor electrodes (2) are n-doped, whilst the semiconductor substrate (1) is p-doped.

9. Conductor crossover according to at least one of the preceding claims, **characterised in that** the semiconductor substrate (1), the semiconductor electrodes (2) and/or the substrate electrode (S) essentially comprise silicon, in particular polysilicon, germanium or gallium arsenide.

10. Conductor crossover according to at least one of the preceding claims, **characterised in that** the connection line (M) is guided over semiconductor electrodes (2) with an annular topology.

11. Conductor crossover according to claim 10, **characterised in that** the connection line (M) is guided over a plurality of semiconductor electrodes which are mutually enclosed.

12. Conductor crossover according to at least one of the preceding claims, **characterised in that** the at least one connection line is guided over a multiplicity of adjacent drift detectors.

13. Drift detector for X-ray spectroscopy which is equipped with at least one conductor crossover according to at least one of the preceding claims.

14. Detector arrangement for X-ray spectroscopy which comprises a multiplicity of drift detectors and is equipped with at least one conductor crossover according to at least one of the preceding claims 1 to 12, which is guided over a plurality of drift detectors.

## Revendications

1. Interconnexion de lignes pour un détecteur à semiconducteurs, en particulier pour un détecteur de dérive pour la spectroscopie à rayons X, comportant
- au moins deux électrodes semi-conductrices (2) dopées, agencées dans un substrat semi-conducteur (1),
- au moins une ligne de raccordement (M), guidée au-dessus des électrodes semi-conductrices (2), et
- une première couche d'isolation (Ox),
**caractérisée en ce que**,
entre la ligne de raccordement (M) et la première couche d'isolation (Ox), est agencée une électrode intermédiaire (L, L2), qui couvre la zone du substrat semi-conducteur (1) entre les électrodes' semi-conductrices (2) et qui est isolée électriquement par rapport à la ligne de raccordement (M) par au moins une couche d'isolation (I) supplémentaire, ladite au moins une électrode intermédiaire (L, L2) protégeant électriquement par rapport à la ligne de raccordement (M) au moins une zone partielle du substrat semi-conducteur (1) entre les électrodes semi-conductrices (2).

2. Interconnexion de lignes selon la revendication 1, **caractérisée en ce que** l'électrode intermédiaire (L) est reliée électriquement à l'une des électrodes semi-conductrices (2) et possède le potentiel électrique de celle-ci.

3. Interconnexion de lignes selon la revendication 2, dans laquelle la liaison entre l'électrode intermédiaire (L) et l'électrode semi-conductrice (2) est formée par une jonction polysilicium-silicium.

4. Interconnexion de lignes selon la revendication 1, **caractérisée en ce que** l'électrode intermédiaire (L, L2), pour définir son potentiel électrique, est reliée à une source de tension externe.

5. Interconnexion de lignes selon au moins l'une des revendications précédentes, **caractérisée en ce que** plusieurs plans avec plusieurs électrodes intermédiaires isolées (L, L2) sont disposés les uns au-dessus des autres entre la ligne de raccordement (M) et le substrat semi-conducteur (1).

6. Interconnexion de lignes selon au moins l'une des revendications précédentes, **caractérisée en ce que**, pour la mise en contact des électrodes semi-conductrices (2) et/ou d'un élément de renfort (T), il est prévu au moins une ligne de raccordement supplémentaire, qui est guidée au-dessus d'électrodes semi-conductrices (2) adjacentes.

7. Interconnexion de lignes selon au moins l'une des revendications précédentes, **caractérisée en ce que** les électrodes semi-conductrices (2) sont dopées p, tandis que le substrat semi-conducteur (1) et/ou l'électrode de lecture (A) sont dopés n.

8. Interconnexion de lignes selon au moins l'une des revendications 1 à 6, **caractérisée en ce que** les électrodes semi-conductrices (2) sont dopées n, tandis que le substrat semi-conducteur (1) est dopé p.

9. Interconnexion de lignes selon au moins l'une des revendications précédentes, **caractérisée en ce que** le substrat semi-conducteur (1), les électrodes semi-conductrices (2) et/ou l'électrode du substrat (S) sont réalisées pour l'essentiel en silicium, en particulier en polysilicium, germanium ou arséniure de gallium.

10. Interconnexion de lignes selon au moins l'une des revendications précédentes, **caractérisée en ce que** la ligne de raccordement (M) est guidée au-dessus d'électrodes semi-conductrices (2) avec une topologie annulaire.

11. Interconnexion de lignes selon la revendication 10, **caractérisée en ce que** la ligne de raccordement (M) est guidée au-dessus de plusieurs électrodes semi-conductrices (2), qui s'entourent réciproquement.

12. Interconnexion de lignes selon au moins l'une des revendications précédentes, **caractérisée en ce que** ladite au moins une ligne de raccordement est guidée au-dessus d'une pluralité de détecteurs de dérive adjacents.

13. Détecteur de dérive pour la spectroscopie à rayons X, lequel est équipé d'au moins une interconnexion de lignes selon au moins l'une des revendications précédentes.

14. Système de détecteurs pour la spectroscopie à rayons X, qui comporte une pluralité de détecteurs de dérive et est équipé d'au moins une interconnexion de lignes selon au moins l'une des revendications précédentes 1 à 12, qui est guidée au-dessus de plusieurs détecteurs de dérive.
